# EUROPÄISCHE PATENTSCHRIFT

(11) **EP 3 231 954 B1**
(45) Veröffentlichungstag und Bekanntmachung des Hinweises auf die Patenterteilung: **26.05.2021**
(21) Anmeldenummer: 17000612.6
(22) Anmeldetag: 11.04.2017
(51) Int. Cl.: E04B 9/18, E04B 9/20

(54) **LÄNGENEINSTELLBARER ABHÄNGER FÜR DAS VERANKERN EINER ABGEHÄNGTEN UNTERDECKE**
LENGTH-ADJUSTABLE HANGER FOR ANCHORING A SUSPENDED FALSE CEILING
SUSPENTE RÉGLABLE EN LONGUEUR POUR L'ANCRAGE D'UNE SOUS-STRUCTURE SUSPENDUE

(30) Priorität: 12.04.2016 AT 1922016
(43) Veröffentlichungstag der Anmeldung: 18.10.2017
(73) Patentinhaber: Baustoff + Metall GmbH, 1230 Wien (AT)
(72) Erfinder: Peer, Robert, 2381 Laab im Walde (AT)

(56) Entgegenhaltungen:
- EP-A1- 1 916 351
- DE-B- 1 280 528
- DE-U1- 29 700 387
- FR-A1- 2 937 987

## Beschreibung

Die Erfindung betrifft einen längeneinstellbaren Abhänger für das Verankern einer abgehängten Unterdecke.

Abhänger im Sinne dieses Dokumentes sind jene Elemente, über welche eine abgehängten Unterdecke an einer tragenden Struktur des Gebäudes - typischerweise einer Rohdecke - befestigt ist. Dabei befindet sich die tragende Struktur in einem Abstand zu dieser oberhalb der Unterdecke. Die Abhänger hängen vertikal von der tragenden Struktur zur Unterdecke und sind durch das Gewicht der Unterdecke auf Zug belastet. Die Abhänger sind in ihrer Länge einstellbar, damit die Unterdecke unabhängig von Unebenheiten der tragenden Struktur jedenfalls horizontal in der gewünschten Höhe angeordnet werden kann.

Bei den meisten angewendeten Bauweisen für längeneinstellbare Abhänger ist eines der beiden folgenden Funktionsprinzipien angewandt:
Das erste Funktionsprinzip ist beispielsweise in der DE 3539373 A1 und der DE 102011013986 A1 gezeigt. Ein gerader, sehr schlanker Teil, typischerweise aus sehr starrem Draht, ragt durch zwei Durchbrüche einer auf Biegung elastisch vorgespannten, etwa U-förmig gekrümmten Biegefeder hindurch. Durch die elastische Vorspannung verkanntet sich der schlanke Teil an den Rändern der Durchbrüche und ist damit an der Biegefeder kraftschlüssig fixiert. Wenn die Biegefeder händisch etwas zusammengedrückt wird, sind der schlanke Teil und die Biegefeder in Längsrichtung des schlanken Teils gegeneinander verschiebbar. Damit ist eine schnelle und stufenlose Längeneinstellbarkeit der überlappenden Länge aus einem mit der Biegefeder starr verbundenen Teil und dem schlanken Teil ermöglicht.

Nachteilig an der Bauweise ist, dass sie für einige Anwendungen, insbesondere dann, wenn an der Unterdecke mit Kraftaufwand herum hantiert werden muss, oder wenn die Unterdecke sehr schwer ist, als zu wenig sicher gegen unbeabsichtigtes Verstellen oder Lösen gilt. Insbesondere ist der Abhänger gegen Druckbelastung in seiner Längsrichtung kaum knickfest.

Das zweite Funktionsprinzip ist beispielsweise in der DE 1280528 B gezeigt. Abhänger die auf diesem Funktionsprinzip basieren, werden gemeinhin - und des Weiteren auch in dieser Anmeldung - als "Noniusabhänger" bezeichnet. Zwei Verbindungsteile haben jeweils einen als Metallprofil ausgebildeten Fortsatz, wobei diese Profile typischerweise U-Profile sind, parallel zueinander ausgerichtet sind, und mit überlappendem Längsbereich längsverschiebbar aneinander anliegen. Beide Profile weisen jeweils eine Reihenlochbohrung auf, wobei die Löcher Durchgangslöcher durch eine Profilwand sind und in Profilrichtung nebeneinander liegen und wobei die Löcher bezüglich der Position in den Querschnittsflächen der Profile so angeordnet sind, dass Löcher im einen Profil mit Löchern im anderen Profil fluchten können. Der Rasterabstand der Löcher im einen Profil ist geringfügig anders als jener im anderen Profil, sodass bei Längsverschiebung der Profile aneinander in schneller Folge verschiedene Paare von zwei zueinander fluchtenden Löchern wechseln. Bei für die jeweilige Montagesituation passenden Gesamtlänge der Verbindungsteile wird durch ein Paar von dann zueinander fluchtenden Löchern in den beiden Profilen ein Stift hindurchgesteckt, sodass weitere Längsverschiebbarkeit der Profile und damit der Verbindungsteile aneinander blockiert ist.

Abhänger dieser Bauweise, also Noniusabhänger, sind fest, auch knickfest, und sicher gegen unbeabsichtigtes Verstellen, unabhängig davon, wie an der abgehängten Unterdecke herumhantiert wird. Nachteilig an der Bauweise ist, dass je Paar von Verbindungsteilen nur ein relativ kleiner Bereich der überlappenden Gesamtlänge abgedeckt werden kann, sodass man in der Praxis nicht mit jeweils einer Größe von Verbindungsteilen auskommt, sondern entweder viele Größen von Verbindungsteilen braucht, oder lange Verbindungsteile bei Bedarf aufwändig kürzen muss.

Von diesem Stand der Technik ausgehend hat sich der Erfinder die Aufgabe gestellt, einen für das Befestigen einer abgehängten Unterdecke an einer über dieser angeordneten tragenden Struktur vorgesehen Nonius-Abhänger gegenüber bekannten Bauweisen dahingehend zu verbessern, dass es damit möglich wird, mit einer einzigen Baugröße von Noniusabhängern, alle gängigen Höhenabstände zwischen Unterdecke und tragender Struktur abzudecken.

Für das Lösen der Aufgabe wird vorgeschlagen, von den beiden Profilen, welche jeweils eine Lochreihe aufweisen, ein Profil so leicht verformbar auszubilden, dass bei der Montage ein überstehender Längsbereich händisch von der vertikalen Ausrichtung in die horizontale Ausrichtung gebogen werden kann - womit er im Raum zwischen Unterdecke und tragender Konstruktion Platz findet ohne zu stören.

Das biegbare Profil kann daher auch dann, wenn es so lang ausgebildet ist, dass es auch größte Abstände zwischen Unterdecke und tragender Struktur überbrücken kann, so umgeformt werden, dass es auch bei kleinsten Abständen zwischen Unterdecke und tragender Struktur angewendet werden kann.

Eine passende Auslegung von Material, Profilform und Wandstärke des zu verformenden Profils, damit dieses von Hand aus ausreichend leicht gebogen werden kann, ist ihm Rahmen des fachmännischen Handelns durch Versuch ohne weiteres möglich, weswegen hier nicht sehr vertiefend darauf eingegangen wird. Als quantitative Zielvorstellung für die Bemessung kann typischerweise davon ausgegangen werden, dass das Profil bei Biegebeanspruchung als einseitig eingespannter Träger mit quer zur Profilrichtung ausgerichteter Punktlast am freien Trägerende bei einer Trägerlänge von 20 cm durch eine Kraft im Größenbereich von 40 N bis 400 N um 90° aus seiner ursprünglichen Ausrichtung biegbar sein sollte.

In einer besonders bevorzugten Ausführungsform ist das leicht verformbare Profil um zu seiner Profilrichtung parallel liegende Biegeachsen so weich verformbar, dass seine Profilform Längenabschnitt für Längenabschnitt von Hand aus zu flacher Streifenform umformbar ist.

Durch diese Verformbarkeit braucht das Profil nicht von vornherein auch um Achsen gut biegbar zu sein, welche normal zur Profilrichtung liegen. Damit wird hohe Positionsstabilität der Unterdecke erreicht.

Als quantitative Zielvorstellung für die Bemessung kann typischerweise davon ausgegangen werden, dass die Verformung der Profilform durch kleinflächig (etwa 1 cm² Angriffsfläche) aufzubringende Kräfte im Größenbereich von 40 N bis 200 N erzielbar sein sollte.

Die Erfindung wird an Hand von stilisierten Zeichnungen der für das Verständnis der Erfindung wesentlichen Einzelteile eines beispielhaften erfindungsgemäßen Abhängers veranschaulicht. Aus Gründen der Anschaulichkeit sind die beiden Verbindungsteile nicht gemeinsam in einer Zeichnung dargestellt, sondern jeweils für sich allen.
Fig. 1: zeigt in Schrägrissansicht den unteren Teil des oberen Verbindungsteiles in jener Form die er in eingebautem Zustand haben kann.
Fig. 2: zeigt in Schrägrissansicht den unteren Verbindungsteil.

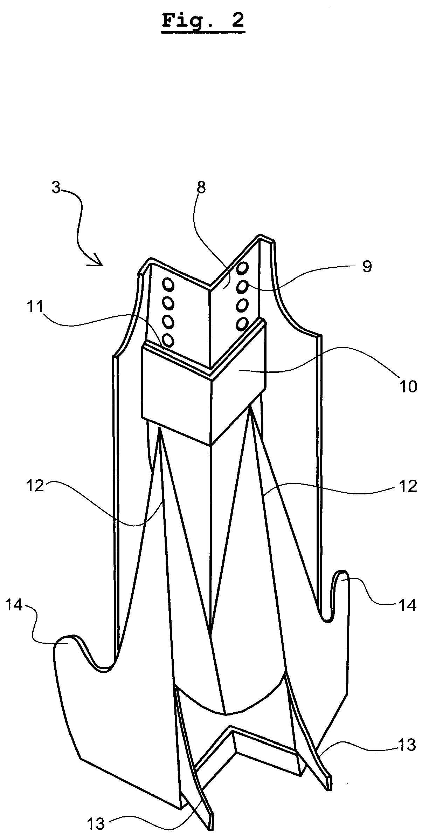

Der untere Teil des oberen Verbindungsteils 1 ist ursprünglich ein gerades Winkelprofil 2. Nach dem erfindungsgemäßen Zusammenbau mit dem in Fig. 2 skizzierten unteren Verbindungsteil 3 ist das Winkelprofil 1 in seinem unteren Längsbereich 4 sowohl aus der Vertikalen heraus gekrümmt, als auch in seiner Profilform in einem kontinuierlichen Übergang zu einem flachen Streifen 5 umgeformt.

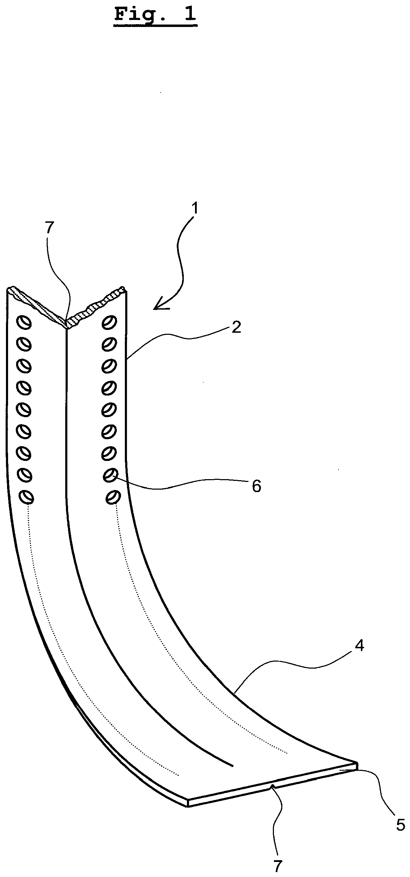

An jedem seiner beiden Schenkel weist das Winkelprofil 2 eine in Profilrichtung verlaufende Lochreihe 6 auf. Diese Lochreihe 6 verläuft in den flachen Streifen 5. In Fig. 1 sind die Lochreihen 6 im Bereich des flachen Streifens 5 durch eine punktierte Linien symbolisiert.

Damit das (plastische) Umformen des unteren Längsbereichs 4 des Winkelprofils 2 von der Winkelprofilform in einen flachen Streifen 5 bei der Montage des Abhängers werkzeuglos möglich sein soll, ist die Wandstärke des Winkelprofils 2 im Stoßbereich der beiden. Winkelschenkel durch eine entlang des Profils verlaufende Kerbe 7 geschwächt.

Typischerweise besteht das Winkelprofil 2 aus einem weichen Stahlblech mit knapp einem mm Wandstärke; im Bereich der Kerbe 7 ist die Wandstärke auf etwa 0,5 mm verringert.

Die wünschenswerte Schwächung des Winkelprofils 2 im Stoßbereich der beiden Winkelschenkel kann auch auf eine andere Art als mittels einer einzigen Kerbe 7 erfolgen. Beispielsweise könnte eine Muldenartige Vertiefung in das Blech geprägt sein, oder es könnte ein Raster von Durchbrüchen in das Blech gebohrt oder gestanzt sein.

Am nicht dargestellten oberen Endbereich des Winkelprofils 2 befindet sich in Einbausituation irgendein Verbindungsbeschlag über welchen das Winkelprofil 2 mit der tragenden Struktur des Gebäudes verbunden ist.

Der in Fig. 2 skizzierte untere Verbindungsteil 3, besteht typischerweise aus gestanztem und gebogenem Stahlblech, welches fester sein kann als jenes vom Winkelprofil 2, da es bestimmungsgemäß weder bei der Montage noch danach noch verformt werden soll.

Der untere Verbindungsteil 3 ist in seinem oberen Längsbereich abschnittsweise als gerades Winkelprofil 8 ausgebildet. In Einbausituation ist diese Winkelprofil 8 vertikal ausgerichtet und im erhaben Winkelbereich zwischen seinen beiden Schenkeln liegt dabei das Winkelprofil 2 des oberen Verbindungsteils 1 in unverformten Zustand an.

Das Winkelprofil 8 weist an jedem seiner beiden Schenkel eine in Profilrichtung verlaufende regelmäßige Lochreihe 9 auf, bei welcher das Rastermaß der Lochmittenabstände geringfügig anders ist als bei den Lochreihen 6 am oberen Verbindungsteil 1, sodass zwischen den beiden Lochreihen 6, 9 die Nonius-Verbindung wie aus dem Stand der Technik bekannt gebildet wird.

Der untere Verbindungsteil 3 weist weiters eine winkelprofilförmige Stützlasche 10 auf, welche unten an das Winkelprofil 8 anschließt und von diesem etwas in dessen erhabenen Winkelbereich verschoben ist, sodass zwischen der Stützlasche 10 und dem Winkelprofil 8 ein offener Spalt 11 gebildet wird, durchwelchen hindurch in Einbausituation das Winkelprofil 2 des oberen Verbindungsteil 1 hindurch verläuft. Die Stützlasche 10 hat die Funktion, Verformung des Winkelprofils 2 in jenem Längsbereich mit dem dieses am Winkelprofil 8 anliegt, zu verhindern.

An die Stützlasche 10 unten schließen am unteren Verbindungsteil zwei Auflaufkanten 12 an, an welchen bestimmungsgemäß bei der Montage die Innenseiten der Schenkel des Winkelprofils 2 des oberen Verbindungsteils anliegen, sodass sie beim Schieben des Winkelprofils 2 entlang des unteren Verbindungsteils 3 nach unten hin, umgeformt werden, sodass seine Winkelschenkel zunehmend in die Parallele zueinander verformt werden und das ganze Winkelprofil mehr und mehr in die Horizontale gebogen wird. An die Auflaufkanten 12 schließt unten jeweils eine Blechlasche 13 an, an welchen bei der Montage der untere Längsbereich 4 des Winkelprofils 2 des oberen Verbindungsteils 1 weiter in die in Fig. 1 skizzierte Form umgeformt wird.

An seinem seitlichen unteren Bereich ist der untere Verbindungsteil 3 mit jeweils einem Fortsatz 14 versehen, welcher zur Verbindung mit einem - nicht dargestellten - Profil der zu befestigenden Unterdecke dient. Dieses Profil hat typischerweise etwa C-Profilform, und die Fortsätze liegen innen an den einwärts gekrümmten seitlichen Profilschenkeln an.

An im Rahmen des Erfindungsgedankens liegenden Verallgemeinerungen zu der skizzierten beispielhaften Ausführung seien ohne Anspruch auf Vollständigkeit kurz genannt bzw. verdeutlicht:
Bezüglich der Funktionsweise können oberer und unterer Verbindungsteil auch vertauscht sein. Das heißt es kann auch der obere Verbindungsteil zur Gänze starr sein und der untere Verbindungsteil ein zu verformendes Profil aufweisen.

Der starre Verbindungsteil braucht nicht zwangsweise mit Kanten oder Flächen versehen sein, an welchen das verformbare Profil des zweiten Verbindungsteils verformt wird. Das notwendige Verformen könnte auch durch ungeführtes Verformen von Hand aus oder unter Anwendung eines separaten Anschlagteiles für das Biegen erfolgen. Einer einfacheren Bauform des starren Verbindungsteils stünde ein Verlust an Komfort beim Montagevorgang gegenüber.

Das zu verformende Profil braucht nicht unbedingt ein Winkelprofil zu sein. Gut anwendbar sind auch U-Profile, oder Profile mit bogenartiger Querschnittsform.

Prinzipiell kann das verformbare Profil auch schon vor der Verformung bei der Montage flach streifenförmig sein, sodass es bei der Montage in seiner Querschnittsform praktisch nicht verändert wird, sondern nur um zur Profilrichtung normal liegende Achsen gebogen wird. Dem Vorteil eines noch einfacheren Montagevorganges steht der Nachteil gegenüber, dass das Profil in einer so leicht zu biegen ist, dass die Gefahr von unerwünschten Biegungen und damit unerwünschtem Verschieben der Unterdecke steigt.

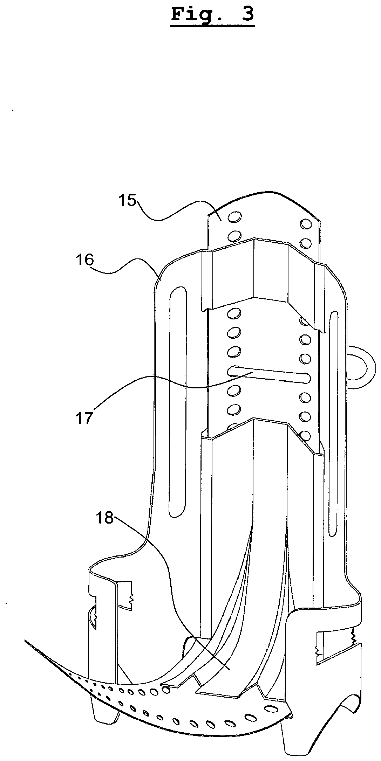

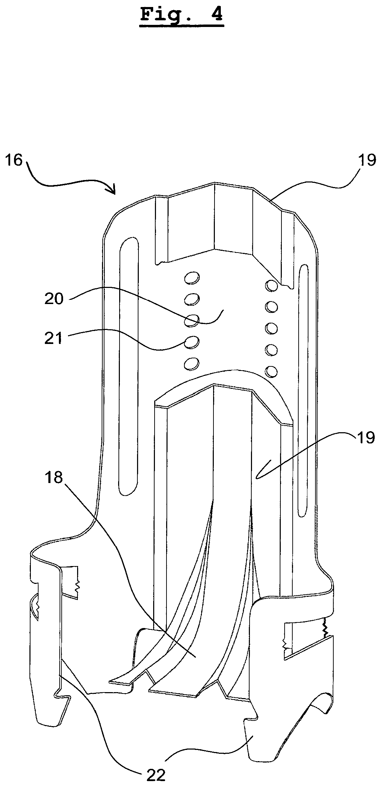

Fig. 3 und Fig. 4 zeigen eine zweite, besonders vorteilhafte Kombination aus oberem Verbindungsteil 15 und unterem Verbindungsteil 16. Fig. 3 zeigt zusätzlich auch einen Stift 17, welcher durch zueinander fluchtende Lochpaare der Lochreihen der beiden Verbindungsteile 15, 16.

Der obere Längsbereich des Verbindungsteils 15 ist wiederum ein gerades Profil, in diesem Fall mit etwa C-förmiger Querschnittsfläche. Am unteren Höhenbereich des unteren Verbindungsteils 16 ist das den oberen Verbindungsteil 15 bildende Profil zu jener Profilseite hin an welcher die Querschnittsfläche des Profils eine Nut aufweist, in die Horizontale umgebogen, wobei sich auch die Profilform zu der eines flachen Streifen umwandelt. Der untere Verbindungsteil 16 weist in jenem Höhenbereich an welchem die Umformung des oberen Verbindungsteils 15 stattfindet eine gekrümmte Fläche 18 auf, welche während des Biegenvorgangs an der Innenseite der Krümmung des oberen Verbindungsteils anliegt und diesen gegen Abknicken abstützt.

Wie unter Zuhilfenahme von Fig. 4 erkennbar ist, weist der untere Verbindungsteil 16 wiederum einen als gerades Profil 19 ausgebildeten Bereich auf, und eine dagegen etwas normal zur Profilrichtung verschobene ansonsten aber gleich ausgerichtete profilförmige Stützlasche 20. Der obere, vertikal ausgerichtete, nicht gekrümmte Längsbereich des oberen Verbindungsteils 15 ist zwischen dem geraden Profil 19 und der Stützlasche 20 durchsteckbar und durch diese Teile gegen Krümmung gestützt. Die zum unteren Verbindungsteil 16 gehörende Lochreihen 21 sind bei der Bauweise gemäß Fig. 3-und Fig. 4 in der Stützlasche 20 ausgebildet.

Wie aus dem Stand der Technik bekannt, weist der untere Verbindungsteil 16 an seinem unteren Längsbereich zwei mit jeweils einem Schlitz versehene Wandbereiche 22 auf, mit Hilfe derer er bestimmungsgemäß sehr gut fest und spielfrei an einer Profilschiene mit C-förmiger, nach oben offener Querschnittsfläche verbindbar ist.

## Patentansprüche

1. Als Noniusabhänger ausgebildeter, längeneinstellbare Abhänger für das Verankern einer abgehängten Unterdecke an einer über dieser angeordneten tragenden Struktur, welcher einen oberen und Verbindungsteil (1, 15) und einen unteren Verbindungsteil (3, 16) aufweist, welche jeweils einen als gerades Profil (2, 8, 19) ausgebildeten Bereich aufweisen, die aneinander anliegen, dabei mit mindestens jeweils einem Paar von Lochreihen (6, 9, 21) aneinander liegen bei denen der Lochabstand unterschiedlich ist und wobei ein Stift (17) durch ein Paar von miteinander fluchtenden Löchern aus beiden Lochreihen (6, 9, 21) steckbar ist,
**dadurch gekennzeichnet, dass**
ein Profil (2) aus der Gruppe der beiden Profile (2, 8, 19) in dem mit einer Lochreihe (6) versehenen Längsbereich so leicht verformbar ist, dass ein von diesem Längsbereich bei der Montage überstehender Teilbereich händisch von der vertikalen Ausrichtung in die horizontale Ausrichtung biegbar ist.

2. Abhänger nach Anspruch 1, **dadurch gekennzeichnet, dass** das Profil (2, 8, 19) eine von der flachen Querschnittsform abweichende Profilform aufweist.

3. Abhänger nach Anspruch 2, **dadurch gekennzeichnet, dass** das Profil (2, 8, 19) Winkel-, U- oder Bogenquerschnittform aufweist.

4. Abhänger nach einem der Ansprüche 1 bis 3, **dadurch gekennzeichnet, dass** das leicht verformbare Profil (2) zwei Teilbereiche aufweist, wobei der eine Teilbereich gerade und vertikal ausgerichtet ist und der zweite Teilbereich abgeflacht und aus der Vertikalen heraus gekrümmt ist.

5. Abhänger nach Anspruch 3 oder 4, **dadurch gekennzeichnet, dass** leicht verformbare Profil (2) um zu seiner Profilrichtung parallel liegende Biegeachsen so weich verformbar ist, dass seine Profilform Längenabschnitt für Längenabschnitt von Hand aus zu flacher Streifenform umformbar ist.

6. Abhänger nach einem der Ansprüche 1 bis 5, **dadurch gekennzeichnet, dass** jener Verbindungsteil (3, 16), von welchem das leicht verformbare Profil (2) nicht Teil ist, eine Längsführung für das leicht verformbare Profil (2) aufweist, durch welche dieses Profil (2) im Zuge der Montage hindurchführbar ist.

7. Abhänger nach Anspruch 6, **dadurch gekennzeichnet, dass** die Längsführung eine Stützlasche (10, 20) umfasst.

8. Abhänger nach einem der Ansprüche 1 bis 7, **dadurch gekennzeichnet, dass** jener Verbindungsteil (3, 16), von welchem das leicht verformbare Profil (2) nicht Teil ist, eine gekrümmte Fläche (18) aufweist, an welcher das leicht verformbare Profil (2) mit der Innenseite seines gekrümmten Längsbereiches anliegt.

9. Abhänger nach einem der Ansprüche 1 bis 8, **dadurch gekennzeichnet, dass** das leicht verformbare Profil (2) ein Winkelprofil ist, welches im Stoßbereich der beiden Winkelschenkel geschwächt ist.

10. Abhänger nach Anspruch 9, **dadurch gekennzeichnet, dass** das Profil (2) im Stoßbereich der beiden Winkelschenkel eine in Profillängsrichtung verlaufende Kerbe (7) aufweist.

## Claims

1. Length-adjustable hanger in the form of a vernier hanger for anchoring a suspended ceiling to a supporting structure arranged above the latter, which has an upper and connecting part (1, 15) and a lower connecting part (3, 16), each of which has a region formed as a straight profile (2, 8, 19) which bear against one another, with at least one pair of rows of holes (6, 9, 21) respectively bearing against one another in which the hole spacing is different, and it being possible for a pin (17) to be inserted through a pair of mutually aligned holes from both rows of holes (6, 9, 21), **characterised in that**
a profile (2) from the group of the two profiles (2, 8, 19) is so easily deformable in the longitudinal region provided with a row of holes (6) that a partial region protruding from this longitudinal region during assembly can be bent manually from the vertical orientation into the horizontal orientation.

2. A hanger according to claim 1, **characterised in that** the profile (2, 8, 19) has a profile shape deviating from the flat cross-sectional shape.

3. A hanger according to claim 2, **characterised in that** the profile (2, 8, 19) has an angular, U-shaped or arch cross-sectional shape.

4. A hanger according to any one of claims 1 to 3, **characterised in that** the easily deformable profile (2) comprises two partial regions, one partial region being straight and vertically oriented and the second partial region being flattened and curved out from the vertical.

5. A hanger according to claim 3 or 4, **characterised in that** the easily deformable profile (2) is so softly deformable on the bending axes lying parallel to its profile direction that its profile shape can be reshaped lengthwise section by lengthwise section by hand into a flat strip shape.

6. A hanger according to any one of claims 1 to 5, **characterised in that** the connecting part (3, 16) of which the easily deformable profile (2) is not part comprises a longitudinal guide for the easily deformable profile (2), through which this profile (2) can be guided in the course of assembly.

7. A hanger according to claim 6, **characterised in that** the longitudinal guide comprises a support bracket (10, 20).

8. A hanger according to any one of claims 1 to 7, **characterised in that** the connecting part (3, 16) of which the easily deformable profile (2) is not part has a curved surface (18) against which the easily deformable profile (2) abuts with the inner side of its curved longitudinal region.

9. A hanger according to any one of claims 1 to 8, **characterised in that** the easily deformable profile (2) is an angle profile which is weakened in the joint region of the two angle legs.

10. A hanger according to claim 9, **characterised in that** the profile (2) has a notch (7) extending in the longitudinal direction of the profile in the joint region of the two angle legs.

## Revendications

1. Dispositif de suspension réglable en longueur, conçu comme suspente Nonius, pour l'ancrage d'un plafond suspendu sur une structure porteuse disposée au-dessus de ce dernier, laquelle présente un élément de liaison supérieur (1, 15) et un élément de liaison inférieur (3, 16), qui présentent respectivement une zone conçue comme profil rectiligne (2, 8, 19), qui sont adjacentes l'une par rapport à l'autre en étant placées l'un contre l'autre avec au moins respectivement une paire de rangées de trous (6, 9, 21) dans lesquelles l'intervalle entre les trous est variable, une tige (17) pouvant être insérée dans une paire de trous alignés à partir des deux rangées de trous (6, 9, 21),
**caractérisé en ce que**
un profil (2) dans le groupe des deux profils (2, 8, 19) peut être facilement déformé dans la zone longitudinale dotée d'une rangée de trous (6) de telle sorte qu'une zone partielle dépassant de cette zone longitudinale lors du montage puisse être courbée manuellement dans l'alignement horizontal depuis l'alignement vertical.

2. Dispositif de suspension conformément à la revendication 1, **caractérisé en ce que** le profil (2, 8, 19) présente une forme de profil différente de la forme en coupe transversale plate.

3. Dispositif de suspension conformément à la revendication 2, **caractérisé en ce que** le profil (2, 8, 19) présente une forme angulaire, en U ou en coupe transversale courbée.

4. Dispositif de suspension conformément à l'une des revendications 1 à 3, **caractérisé en ce que** le profil (2) très malléable présente deux zones partielles, une zone partielle étant alignée de façon rectiligne et verticale et la deuxième zone partielle étant aplatie et incurvée depuis la verticale.

5. Dispositif de suspension conformément à la revendication 3 ou 4, **caractérisé en ce que** le profil (2) très malléable est facilement déformable autour d'axes de flexion parallèles à sa direction de profil de telle sorte que sa forme de profil soit transformable manuellement section de longueur par section de longueur à partir de la forme de bande trop plate.

6. Dispositif de suspension conformément à l'une des revendications 1 à 5, **caractérisé en ce que** l'élément de liaison (3, 16) dont le profil (2) très malléable ne fait pas partie intégrante, présente un guidage longitudinal pour le profil (2) très malléable, à travers lequel ce profil (2) peut être introduit pendant le montage.

7. Dispositif de suspension conformément à la revendication 6, **caractérisé en ce que** le guidage longitudinal comprend une patte d'appui (10, 20).

8. Dispositif de suspension conformément à l'une des revendications 1 à 7, **caractérisé en ce que** l'élément de liaison (3, 16) dont le profil (2) très malléable ne fait pas partie intégrante, présente une surface (18) incurvée, contre laquelle est placé le profil (2) très malléable avec la face intérieure de sa zone longitudinale incurvée.

9. Dispositif de suspension conformément à l'une des revendications 1 à 8, **caractérisé en ce que** le profil (2) très malléable est un profil angulaire qui est atténué dans la zone de jonction des deux côtés angulaires.

10. Dispositif de suspension conformément à la revendication 9, **caractérisé en ce que** le profil (2) présente, dans la zone de jonction des deux côtés angulaires, une encoche (7) passant dans le sens longitudinal du profil.
